(19) Europäisches Patentamt
European Patent Office
Office européen des brevets

(11) EP 1 909 552 A1

(12) **EUROPEAN PATENT APPLICATION**
published in accordance with Art. 153(4) EPC

(43) Date of publication:
**09.04.2008 Bulletin 2008/15**

(21) Application number: **06780809.7**

(22) Date of filing: **05.07.2006**

(51) Int Cl.:
***H05K 9/00*** *(2006.01)* ***B32B 9/00*** *(2006.01)*
***B32B 15/04*** *(2006.01)* ***G09F 9/00*** *(2006.01)*

(86) International application number:
**PCT/JP2006/313433**

(87) International publication number:
**WO 2007/007622 (18.01.2007 Gazette 2007/03)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.07.2005 JP 2005198507**
**26.10.2005 JP 2005311169**

(71) Applicant: **Asahi Glass Company, Limited**
**Chiyoda-ku**
**Tokyo 100-8405 (JP)**

(72) Inventors:
- **MORIMOTO, Tamotsu**
  **c/o Asahi Glass Company, Limited**
  **Tokyo 1008405 (JP)**
- **KONISHI, Masaaki**
  **c/o Asahi Glass Company, Limited**
  **Tokyo 1008405 (JP)**
- **KAWASAKI, Masato**
  **c/o Asahi Glass Company, Limited**
  **Tokyo 1008405 (JP)**
- **OYAMA, Takuji**
  **c/o Asahi Glass Company, Limited**
  **Tokyo 1008405 (JP)**

(74) Representative: **Müller-Boré & Partner**
**Patentanwälte**
**Grafinger Strasse 2**
**81671 München (DE)**

# (54) ELECTROMAGNETIC WAVE SHIELDING FILM AND PROTECTIVE PLATE FOR PLASMA DISPLAY PANEL

(57) To provide an electromagnetic wave shielding film for a PDP having a low luminous reflectance even without providing a protective film, and a protective plate for a PDP having a low luminous reflectance using the electromagnetic wave shielding film for a PDP.

An electromagnetic wave shielding film 10, which comprises a substrate 11 and an electroconductive film 12, wherein the electroconductive film 12 has a multilayer structure in which (n+1) (wherein n is an integer of from 3 to 5) inorganic layers 12a having a refractive index of from 1.55 to 2.5 and n metal layers 12b are alternately laminated from the substrate 11 side; each inorganic layer 12a is a layer containing at least one member selected from a metal oxide, a metal nitride and a metal oxynitride; each metal layer 12b is a layer made of pure silver or a silver alloy; and the second to n-th metal layers from the substrate are thicker than the first metal layer from the substrate, is used.

Fig. 1

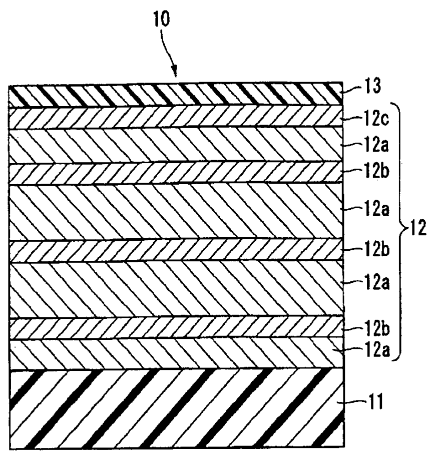


EP 1 909 552 A1

## Description

TECHNICAL FIELD

The present invention relates to an electromagnetic wave shielding film for a plasma display panel (hereinafter referred to as a PDP) having electromagnetic wave shielding properties for shielding electromagnetic noises generated from a PDP provided on the observer side of the PDP to protect the PDP main body, and a protective plate for a PDP.

BACKGROUND ART

Since electromagnetic waves are emitted from the front of a PDP, for the purpose of shielding the electromagnetic waves, a protective plate for a PDP having an electromagnetic wave shielding film comprising a substrate such as a plastic film and an electroconductive film formed on the substrate is disposed on the observer side of a PDP.

For example, Patent Document 1 proposes a protective plate for a PDP comprising a multilayer electroconductive film in which an oxide layer containing as the main component zinc oxide containing at least one metal and a metal layer containing silver as the main component are alternately laminated from the substrate side in a total layer number of (2n+1) (wherein n is a positive integer) and a protective film to protect the electroconductive film.

However, in recent years, a protective plate for a PDP without any protective film has been proposed from such reasons that (i) it is no more necessary to provide a protective film along with high functionality of an electroconductive film, (ii) a protective plate for a PDP is required to be thin, etc. (e.g. Patent Document 2).

However, since the protective film and the air differ in the refractive index, for example, if the protective film is removed from the protective plate for a PDP as disclosed in Patent Document 1, the luminous reflectance of the protective plate for a PDP will increase.

Patent Document 1: WO98/13850

Patent Document 2: U.S.P. 6,391,462

DISCLOSURE OF THE INVENTION

OBJECT TO BE ACCOMPLISHED BY THE INVENTION

The object of the present invention is to provide an electromagnetic wave shielding film for a PDP capable of suppressing the luminous reflectance of a protective plate for a PDP low even without a protective film, and a protective plate for a PDP which requires no protective film and which has a low luminous reflectance.

MEANS TO ACCOMPLISH THE OBJECT

The electromagnetic wave shielding film for a PDP of the present invention is an electromagnetic wave shielding film for a PDP, which comprises a substrate and an electroconductive film formed on the substrate, wherein the electroconductive film has a multilayer structure in which (n+1) (wherein n is an integer of from 3 to 5) inorganic layers having a refractive index of from 1.55 to 2.5 and n metal layers are alternately formed from the substrate side. Further, each inorganic layer is a layer containing at least one member selected from the group consisting of a metal oxide, a metal nitride and a metal oxynitride, and each metal layer is a layer made of pure silver or a layer made of a silver alloy containing at least one member selected from the group consisting of gold, palladium and bismuth. Further, the electromagnetic wave shielding film for a PDP is characterized in that the second, third, ··· and n-th (hereinafter sometimes represented as "the second to n-th") metal layers from the substrate side are thicker than the first metal layer from the substrate.

The i-th (wherein i is an integer of from 2 to n) metal layer from the substrate is preferably thicker than the (i-1)-th metal layer from the substrate.

n is preferably 3.

The electromagnetic wave shielding film for a PDP of the present invention preferably further has an antifouling agent layer on the electroconductive layer.

Each inorganic layer preferably contains at least one member selected from the group consisting of zinc oxide, indium oxide, tin oxide, titanium oxide and niobium oxide.

Each inorganic layer is preferably a layer made of zinc oxide containing at least one element selected from the group consisting of tin, aluminum, chromium, titanium, silicon, boron, magnesium and gallium.

The protective plate for a PDP of the present invention comprises a support and the electromagnetic wave shielding film for a PDP of the present invention formed on the support. It is preferred that the surface of the substrate opposite from the surface on which the electroconductive film is formed in the electromagnetic wave shielding film for a PDP, and one surface of the support, are bonded.

The PDP of the present invention preferably comprises the above protective plate for a PDP disposed so that the surface on the electroconductive film side of the protective plate for a PDP is on the PDP side.

EFFECTS OF THE INVENTION

The electromagnetic wave shielding film for a PDP of the present invention can suppress the luminous reflectance of a protective plate for a PDP low even without a protective film.

The protective plate for a PDP of the present invention requires no protective film and has a low luminous reflectance.

In the PDP of the present invention, the protective plate for a PDP is disposed so that the surface on the electroconductive film side of the protective plate for a PDP is on the PDP side. Accordingly, the surface of the electroconductive film of the protective plate for a PDP is hardly touched by human, and accordingly, it is not necessary to provide a protective film on the surface of the electroconductive film.

BRIEF DESCRIPTION OF THE DRAWINGS

Fig. 1 is a cross-section illustrating one example of an electromagnetic wave shielding film for a PDP of the present invention.
Fig. 2 is a cross-section illustrating one example of a protective plate for a PDP of the present invention.
Fig. 3 is a graph illustrating transmission spectra of electromagnetic wave shielding films for a PDP in Examples 1 and 17.
Fig. 4 is a graph illustrating reflection spectra of electromagnetic wave shielding films for a PDP in Examples 1 and 17.
Fig. 5 is a graph illustrating transmission spectra of protective plates for a PDP in Examples 2 and 18.
Fig. 6 is a graph illustrating reflection spectra of protective plates for a PDP in Examples 2 and 18.
Fig. 7 is a cross-section illustrating another example of the electromagnetic wave shielding film for a PDP of the present invention.
Fig. 8 is a graph illustrating transmission spectra of electromagnetic wave shielding films for a PDP in Examples 3 and 19.
Fig. 9 is a graph illustrating reflection spectra of electromagnetic wave shielding films for a PDP in Examples 3 and 19.
Fig. 10 is a cross-section illustrating another example of the electromagnetic wave shielding film for a PDP of the present invention.
Fig. 11 is a graph illustrating a transmission spectrum of an electromagnetic wave shielding film for a PDP in Example 5.
Fig. 12 is a graph illustrating a reflection spectrum of an electromagnetic wave shielding film for a PDP in Example 5.

MEANINGS OF SYMBOLS

| | |
|---|---|
| 1: | protective plate for a PDP |
| 10: | electromagnetic wave shielding film |
| 11: | substrate |
| 12: | electroconductive film |
| 12a: | inorganic layer |
| 12b: | metal layer |
| 14: | electromagnetic wave shielding film |
| 15: | electromagnetic wave shielding film |
| 20: | support |

BEST MODE FOR CARRYING OUT THE INVENTION

(ELECTROMAGNETIC WAVE SHIELDING FILM FOR A PDP)

Fig. 1 is a cross-section schematically illustrating one example of an electromagnetic wave shielding film for a PDP of the present invention (hereinafter abbreviated as an electromagnetic wave shielding film). An electromagnetic wave shielding film 10 schematically comprises a substrate 11, an electroconductive film 12 formed on the substrate 11, and an antifouling agent layer 13 formed on the electroconductive film 12.

(Substrate)

The substrate 11 is preferably a transparent substrate. The "transparent" means being transparent to at least 60% of light at a wavelength in the visible region. The transparent substrate is preferably transparent to at least 80% of light at a wavelength in the visible region, more preferably at least 90%.

A material of the transparent substrate may, for example, be glass (including tempered glass such as air-pulled tempered glass or chemically tempered glass); or a plastic such as polyethylene terephthalate (PET), triacetyl cellulose (TAC), polycarbonate (PC) or polymethyl methacrylate (PMMA).

(Electroconductive film)

The electroconductive film 12 has a multilayer structure in which (n+1) (wherein n is an integer of from 3 to 5) inorganic layers 12a and n metal layers 12b are alternately laminated from the substrate 11 side. The electroconductive film 12 in Fig. 1 is an example wherein n=3. When 3 to 5 metal layers 12b are formed, the resistance of the electroconductive film 12 can be made low, and the reflection band can be broadened. Further, when 3 metal layers 12b are formed, it is possible to suppress an increase in the internal stress and a decrease in the light transparency.

Each inorganic layer 12a contains at least one member selected from the group consisting of a metal oxide, a metal nitride and a metal oxynitride. Further, the inorganic layer 12a has a refractive index of from 1.55 to 2.5, preferably from 1.8 to 2.5, particularly preferably from 1.9 to 2.5. When the refractive index is within this range, the transmittance can be increased by the interference effect with the metal layer 12b. The "refractive index" means a refractive index at a wavelength of 555 nm.

A metal oxide having a refractive index of from 1.55 to 2.5 may be a metal oxide containing, as the main component, aluminum oxide, zinc oxide, indium oxide, titanium oxide, niobium oxide, tin oxide or the like. Among them, zinc oxide is preferably contained as the main component, which has compatibility with silver in the metal layer 12b and can increase durability of the electroconductive film 12. From the viewpoint of the refractive index, indium oxide, titanium oxide or niobium oxide is preferably contained as the main component.

A metal nitride having a refractive index of from 1.55 to 2.5 may be a metal nitride containing, as the main component, silicon nitride ($Si_3N_4$), aluminum nitride (AlN) or the like.

A metal oxynitride having a refractive index of from 1.55 to 2.5 may be a metal oxynitride containing, as the main component, silicon oxynitride (SiON), aluminum oxynitride (AlON) or the like.

The inorganic layer 12a is preferably a layer made of zinc oxide containing at least one element selected from the group consisting of tin, aluminum, chromium, titanium, silicon, boron, magnesium and gallium. Particularly preferably the inorganic layer 12a is a layer made of zinc oxide containing aluminum (hereinafter referred to as AZO), zinc oxide containing gallium (hereinafter referred to as GZO) or zinc oxide containing titanium (hereinafter referred to as TZO).

In a case where AZO is used for the inorganic layer 12a, it is considered that zinc and aluminum are present as zinc oxide and aluminum oxide or as a mixture of composite oxides thereof. Further, in a case where GZO is used for the inorganic layer 12a, it is considered that zinc and gallium are present as zinc oxide and gallium oxide or as a mixture of composite oxides thereof. Further, in a case where TZO is used for the inorganic layer 12a, it is considered that zinc and titanium are present as zinc oxide and titanium oxide or as a mixture of composite oxides thereof.

The inorganic layer 12a contains $Al_2O_3$, $Ga_2O_3$ or $TiO_2$ and ZnO in a total amount of preferably at least 90 mass%, more preferably at least 95 mass%, particularly preferably at least 99 mass% as calculated as oxides.

In AZO, aluminum is considered to be usually present as aluminum oxide. Further, in GZO, gallium is considered to be usually present as gallium oxide. Further, in TZO, titanium is considered to be usually present as titanium oxide.

The refractive index of AZO depends on the content of aluminum oxide and is from 1.9 to 2.5, and an inorganic layer 12a made of AZO functions also as a high refractive index layer. Further, the refractive index of GZO depends on the content of gallium oxide and is from 1.9 to 2.5, and an inorganic layer 12a made of GZO functions also as a high refractive index layer. Further, the refractive index of TZO depends on the content of titanium oxide and is from 1.5 to 2.5, and an inorganic layer 12a made of TZO functions also as a high refractive index layer.

AZO, GZO or TZO in the inorganic layer 12a contains zinc oxide and thereby has crystallinity analogous to silver. Accordingly, it is likely to crystallize silver in the metal layer 12b formed on the surface of the inorganic layer 12a. Further, the inorganic layer 12a contains aluminum, gallium or titanium and is thereby capable of reducing the internal stress of the inorganic layer 12a. Accordingly, in a case where AZO, GZO or TZO is used for the inorganic layer 12a, migration of silver can be prevented, electrical conductivity can be increased, and the internal stress of the inorganic layer 12a can be reduced.

In a case where AZO or GZO is used for the inorganic layer 12a, the amount of aluminum or gallium is preferably from 1 to 10 at% based on the total amount of aluminum or gallium and zinc. When it is at least 1 at%, the internal stress of the inorganic layer 12a can sufficiently be reduced, and adhesion between the inorganic layer 12a and the metal layer 12b can be maintained. As a result, favorable moistureproof properties will be obtained. Further, when it is at most 10 at%, moistureproof properties can be kept. This is considered to be because when the proportion of aluminum or gallium is below a certain level, crystallinity of zinc oxide can be kept, and compatibility with silver can be maintained. The amount of aluminum or gallium is more preferably from 2 to 6 at%, particularly preferably from 1.5 to 5.5 at% so as to obtain the inorganic layer 12a having a low internal stress stably with high reproducibility and considering crystallinity of zinc oxide.

In a case where TZO is used for the inorganic layer 12a, the amount of titanium is preferably from 2 to 20 at% based on the total amount of titanium and zinc. When it is at least 2 at%, the internal stress of the inorganic layer 12a can sufficiently be reduced, and the adhesion between the inorganic layer 12a and the metal layer 12b can be maintained. As a result, favorable moistureproof properties will be obtained. Further, when it is at most 20 at%, moistureproof properties can be kept. This is considered to be because the proportion of titanium is below a certain level, crystallinity of zinc oxide can be kept, and compatibility with silver can be maintained. The amount of titanium is more preferably from 3 to 15 at% so as to obtain the inorganic layer 12a having a low internal stress stably with high reproducibility and considering crystallinity of zinc oxide.

The physical thickness (hereinafter referred to simply as a thickness) of each of the inorganic layer 12a closest to the substrate 11 and the inorganic layer 12a farthest from the substrate 11 is preferably from 10 to 60 nm, more preferably from 20 to 60 nm, particularly preferably from 30 to 50 nm. The thickness of the other inorganic layers 12a is preferably from 40 to 140 nm, particularly preferably from 40 to 100 nm. The thicknesses of the respective inorganic layers 12a in the electroconductive film 12 may be the same or different.

One inorganic layer 12a may consist of one homogeneous layer or may consist of two or more different inorganic layers. The respective inorganic layers 12a in the electroconductive film 12 may have the same structure or different structures. For example, one inorganic layer 12a may have a two layer structure of AZO layer/silicon dioxide layer; a two layer structure of zinc oxide layer/niobium oxide layer; a two layer structure of TZO layer/niobium oxide layer; a three layer structure of AZO layer/silicon dioxide layer/AZO layer; a three layer structure of AZO layer/tin oxide layer/AZO layer; a three layer structure of zinc oxide layer/tin oxide layer/zinc oxide layer; a three layer structure of zinc oxide layer/silicon dioxide layer/zinc oxide layer; a three layer structure of zinc oxide layer/silicon nitride layer/zinc oxide layer; a three layer structure of zinc oxide layer/niobium oxide layer/zinc oxide layer; or a three layer structure of TZO layer/niobium oxide layer/TZO layer.

In such a case, so long as the average refractive index of one inorganic layer 12a is from 1.55 to 2.5, the inorganic layer may have a layer having a refractive index out of the range of from 1.55 to 2.5. The "average refractive index" is the refractive index averaged obtained by weighting the refractive indices of the respective layers constituting one inorganic layer 12a with the thicknesses, and is determined from the following formula (1):

$$\bar{n} = \frac{\sum_{j=1}^{m} n_j d_j}{\sum_{j=1}^{m} d_j} \quad \cdots (1)$$

wherein m is the number of layers constituting the inorganic layer 12a, $n_j$ is the refractive index of the j-th layer, and $d_j$ is the thickness of the j-th layer.

The metal layer 12b is preferably a layer made of pure silver with a view to lowering the resistance of the electroconductive film 12. In the present invention, the "pure silver" means that the metal layer 12b (100 mass%) contains silver in an amount of 99.9 mass% or more.

The metal layer 12b is preferably a layer made of a silver alloy containing at least one other metal selected from the group consisting of gold, palladium and bismuth with a view to suppressing migration of silver and thus increasing moistureproof properties. The total amount of other metal is preferably from 0.2 to 2.0 mass%, more preferably from 0.2 to 1.5 mass% in the metal layer 12b (100 mass%) so that the resistivity will be at most 1.0 uΩ·cm, particularly at most 5 μΩ·cm.

In the present invention, it is required that the second to n-th metal layers 12b from the substrate 11 are thicker than the first metal layer 12b from the substrate 11, whereby the luminous reflectance of a protective plate for a PDP can be suppressed low even without a protective film. Whereas, in a protective plate for a PDP with four metal layers disclosed in Patent Document 1, the thickness of the fourth metal layer from the substrate is the same as the thickness of the first metal layer, and accordingly, if no protective film is provided, the luminous reflectance of the protective plate for a PDP tends to be high.

As the thickness ratio of the respective metal layers 12b, when the thickness of the first metal layer 12b from the substrate 11 is 1, the second to n-th metal layers 12b from the substrate 11 have a thickness of preferably from 1.1 to 2.5, more preferably from 1.2 to 1.8.

Further, in the present invention, the i-th (wherein i is an integer of from 2 to n) metal layer 12b from the substrate 11 is preferably thicker than the (i-1)th metal layer 12b from the substrate 11. Namely, it is preferred that the respective metal layers 12b in the electroconductive film 12 of the present invention become thick in the order so that the first from the substrate 11 is the thinnest and the i-th is the thickest, whereby the luminous reflectance of the protective plate for a PDP can be suppressed further low.

For example, in a case where three metal layers 12b are formed, it is preferred that the second metal layer 12b from the substrate 11 is thicker than the first metal layer 12b from the substrate 11, and that the third metal layer 12b from the substrate 11 is thicker than the second metal layer 12b from the substrate 11.

Whereas, in the protective plate for a PDP using three metal layers as disclosed in Patent Document 1, the second metal layer from the substrate is thicker than the first and third metal layers, and accordingly, the luminous reflectance of the protective plate for a PDP is high if no protective film is provided.

As the thickness ratio of the respective metal layers 12b, when the thickness of the (i-1)-th metal layer 12b from the substrate 11 is 1, the i-th metal layer from the substrate 11 has a thickness of preferably. from 1.05 to 2.5, more preferably from 1.05 to 2.0.

In a case where the number of the metal layers 12b is 3, as the thickness ratio of the respective metal layers 12b, when the first metal layer 12b from the substrate 11 is 1, the second metal layer 12b from the substrate 11 is preferably from 1.1 to 2.0, more preferably from 1.2 to 1.5. Further, when the thickness of the second metal layer 12b from the substrate 11 is 1, the thickness of the third metal layer 12b from the substrate 11 is preferably from 1.05 to 1.5, more preferably from 1.05 to 1.4.

In a case where the number of the metal layers 12b is 4, as the thickness ratio of the respective metal layers 12b, when the thickness of the first metal layer 12b from the substrate 11 is 1, the thickness of the second metal layer 12b from the substrate 11 is preferably from 1.1 to 2.5, more preferably from 1.2 to 2.0. Further, when the thickness of the second metal layer 12b from the substrate 11 is 1, the thickness of the third metal layer 12b from the substrate 11 is preferably from 1.05 to 1.5, more preferably from 1.05 to 1.4. Further, when the thickness of the third metal layer 12b from the substrate 11 is 1, the thickness of the fourth metal layer 12b from the substrate 11 is preferably from 0.7 to 1.5, more preferably from 0.9 to 1.2, furthermore preferably from 1.05 to 1.2.

In a case where the number of the metal layers 12b is 5, as the thickness ratio of the respective metal layers 12b, when the thickness of the first metal layer 12b from the substrate 11 is 1, the thickness of the second metal layer 12b from the substrate 11 is preferably from 1.1 to 2.5, more preferably from 1.2 to 2.0. Further, when the thickness of the second metal layer 12b from the substrate 11 is 1, the thickness of the third metal layer 12b from the substrate 11 is preferably from 1.05 to 1.5, more preferably from 1.05 to 1.4. Further, when the thickness of the third metal layer 12b from the substrate 11 is 1, the thickness of the fourth metal layer 12b from the substrate 11 is preferably from 0.7 to 1.5, more preferably from 0.9 to 1.2, furthermore preferably from 1.05 to 1.2. Further, when the thickness of the fourth metal layer 12b from the substrate 11 is 1, the thickness of the fifth metal layer 12b from the substrate 11 is preferably from 0.7 to 1.5, more preferably from 0.9 to 1.2, furthermore preferably from 1.05 to 1.2.

The total thickness of all the metal layers 12b is, for example, in a case where the desired surface resistance of an electromagnetic wave shielding film 10 to be obtained is 1.8 Ω/□, preferably from 25 to 35 nm, more preferably from 28 to 32 nm. When the desired surface resistance is 1.5 Ω/□, it is preferably from 30 to 40 nm, more preferably from 32 to 36 nm. With respect to the thickness of each metal layer 12b, the total thickness is properly allocated among the respective metal layers 12b. Since the specific resistivities of the respective metal layers 12b increase as the number of the metal layers 12b increases, the total thickness tends to increase so as to lower the surface resistance.

A waterproof layer 12c is a layer which protects the inorganic layers 12a and the metal layers 12b from moisture. The waterproof layer 12c is an optional constituent in the present invention and may be omitted.

The waterproof layer 12c may, for example, be a film of an oxide or a film of a nitride of a metal such as tin, indium, titanium or silicon. The waterproof layer 12c is particularly preferably an indium tin oxide (ITO) layer.

The thickness of the waterproof layer 12c is preferably from 2 to 30 nm, more preferably from 3 to 20 nm.

A method of forming the electroconductive film 12 (inorganic layers 12a, metal layers 12b and waterproof layer 12c) may, for example, be sputtering, vacuum vapor deposition, ion plating or chemical vapor deposition. Among them, sputtering is preferred in view of the stability of quality and properties.

Formation of the electroconductive film 12 by sputtering may be carried out, for example, as follows. First, pulse sputtering is conducted on the surface of the substrate 11 using a zinc oxide target containing aluminum, gallium or titanium for the inorganic layer 12a by introducing an argon gas with which an oxygen gas is mixed to form an inorganic layer 12a. The amount of aluminum or gallium in the zinc oxide target containing aluminum or gallium is preferably from 1 to 10 at%, more preferably from 2 to 6 at%, particularly preferably from 1.5 to 5.5 at% based on the total amount of aluminum or gallium and zinc in view of the moistureproof properties and reduction of the internal stress. The amount of titanium in the zinc oxide target containing titanium is preferably from 2 to 20 at%, more preferably from 3 to 15 at% based on the total amount of titanium and zinc in view of the moistureproof properties and reduction of the internal stress.

Then, pulse sputtering is conducted by using a pure silver or silver alloy target by introducing an argon gas to form a metal layer 12b. Such operations are repeatedly carried out and finally, an inorganic layer 12a is formed by the above method to form an electroconductive film 12 having a multilayer structure.

(Antifouling agent layer)

An antifouling agent layer 13 is provided as the case requires on the electroconductive film 12 so as to prevent attachment of stains to increase antifouling properties of the electroconductive film 12.

The antifouling agent layer 13 is preferably an oil repellent film containing a perfluorosilane, a fluorocarbon or the like.

A method of forming the antifouling agent layer 13 may, for example, be vacuum vapor deposition, sputtering or coating and drying.

The refractive index of the antifouling agent layer 13 is preferably from 1.3 to 1.5, more preferably from 1.3 to 1.4.

The thickness of the antifouling agent layer 13 is preferably from 2 to 30 nm, more preferably from 5 to 30 nm, particularly preferably from 10 to 20 nm. When the thickness of the antifouling agent layer 13 is at least 2 nm, sufficient antifouling properties will be obtained. Further, when it is at most 30 nm, the luminous reflectance of the electromagnetic wave shielding film can be made low.

The surface resistance of the electromagnetic wave shielding film 10 is preferably from 0.1 to 3.0 Ω/□, more preferably from 0.1 to 2.5 Ω/□, particularly preferably from 0.1 to 2.0 Ω/□, so as to sufficiently maintain electromagnetic wave shielding properties.

In order to improve visibility of a PDP, the electromagnetic wave shielding film 10 has a transmittance of preferably at least 50%, more preferably at least 60%, furthermore preferably at least 70%.

In order to improve visibility of a PDP, the electromagnetic wave shielding film 10 preferably has sufficiently low surface reflectance. The reflectance of the film itself on the coated surface alone is preferably at most 1.0%, more preferably at most 0.5%, furthermore preferably at most 0.3%.

Further, the electromagnetic wave shielding film 10 is preferably one having a transmittance at a wavelength of 850 nm of at most 5%, particularly preferably at most 2%.

(PROTECTIVE PLATE FOR A PDP)

Fig. 2 is a cross-section schematically illustrating one example of a protective plate for a PDP of the present invention. A protective plate 1 for a PDP comprises a support 20, an electromagnetic wave shielding film 10 formed on the support 20, a color ceramic layer 30 provided at a peripheral portion on the surface on the electromagnetic wave shielding film 10 side of the support 20, and a shatterproof film 40 bonded on the opposite side of the support 20 from the electromagnetic wave shielding film 10 side.

The electromagnetic wave shielding film 10 and the support 20, and the support 20 and the shatterproof film 40 are bonded via an adhesive layer 70.

Further, in the protective plate 1 for a PDP, the electromagnetic wave shielding film 10 is provided on the PDP side of the support 20.

In the protective plate for a PDP of the present invention, it is preferred that the surface of the substrate 11 opposite from the surface on which the electroconductive film 12 is formed in the electromagnetic wave shielding film 10 for a PDP, and one surface of the support 20, are bonded.

(Support)

The support 20 is a transparent substrate having higher rigidity than that of the substrate 11 of the electromagnetic wave shielding film 10. By providing the support 20, no warpage will occur by the temperature difference caused between the surface on the PDP side and the opposite side, even if the material of the substrate 11 of the electromagnetic wave shielding film 10 is a plastic such as a PET.

As a material of the support 20, the same material as the above-described material of the substrate 11 of the electromagnetic wave shielding film 10 may, for example, be mentioned.

In the electromagnetic wave shielding film for a PDP of the present invention, in a case where the material of the substrate 11 is a material having high rigidity such as glass, it is preferred to use no support 20.

(Color ceramic layer)

The color ceramic layer 30 is a layer to mask a joint between the electromagnetic wave shielding film 10 and a PDP chassis so that it will not directly be seen from the observer side. The color ceramic layer 30 can be formed, for example, by printing on the support 20 or by bonding a color tape.

(Shatterproof film)

The shatterproof film 40 is laminated on the surface of the support 20 opposite from the surface on which the electromagnetic wave shielding film 10 is laminated. Further, in a case where the material of the substrate 11 is a material having high rigidity such as glass and the protective plate has no support 20, the shatterproof film 40 is laminated on the surface of the substrate 11 opposite from the side on which the electroconductive film is formed. The shatterproof film 40 is a film to prevent flying of fragments of the support 20 when the support 20 is damaged. As the shatterproof film 40, one used for a conventional protective plate for a PDP may be mentioned. Particularly when a urethane resin film having self-healing properties which heals by itself when damaged is used, not only shatterproof properties but also self-healing properties will be obtained.

The shatterproof film 40 may have an antireflection function. A film having both shatterproof function and antireflection function may, for example, be ARCTOP (manufactured by Asahi Glass Company, Limited, tradename). ARCTOP is a polyurethane type flexible resin film having self-healing properties and shatterproof properties, having a low refractive index antireflection layer made of an amorphous fluoropolymer formed on one side of the film to apply antireflection treatment.

The shatterproof film 40 is preferably laminated on the surface of the support 20 opposite from the surface on which the electromagnetic wave shielding film 10 is laminated.

(Adhesive layer)

An adhesive of the adhesive layer 70 may be a commercially available adhesive. For example, it may be an adhesive such as an acrylic ester copolymer, a polyvinyl chloride, an epoxy resin, a polyurethane, a vinyl acetate copolymer, a styrene/acrylic copolymer, a polyester, a polyamide, a polyolefin, a styrene/butadiene copolymer type rubber, a butyl rubber or a silicone resin. Among them, an acrylic adhesive is particularly preferred with which favorable moistureproof properties are achieved.

In the adhesive layer 70, additives having various functions such as an ultraviolet absorber may be blended.

(Electroconductive mesh film)

The protective plate for a PDP of the present invention may have an electroconductive mesh film.

The electroconductive mesh film is one comprising a transparent film and an electroconductive mesh layer made of copper formed on the transparent film. Usually, it is produced by bonding a copper foil to a transparent film and processing the laminate into a mesh.

The copper foil may be either rolled copper or electrolytic copper, and known one is used property according to need. The copper foil may be subjected to surface treatment. The surface treatment may, for example, be chromate treatment, surface roughening, acid wash or zinc chromate treatment. The thickness of the copper foil is preferably from 3 to 30 μm, more preferably from 5 to 20 μm, particularly preferably from 7 to 10 μm. When the thickness of the copper foil is at most 30 μm, the etching time can be shortened, and when it is at least 3 μm, high electromagnetic wave shielding properties will be achieved.

The open area of the electroconductive mesh layer is preferably from 60 to 95%, more preferably from 65 to 90%, particularly preferably from 70 to 85%.

The shape of the openings of the electroconductive mesh layer is an equilateral triangle, a square, an equilateral hexagon, a circle, a rectangle, a rhomboid or the like. The open areas are preferably uniform in shape and aligned in a plane.

With respect to the size of the openings, one side or the diameter is preferably from 5 to 200 μm, more preferably from 10 to 150 μm. When one side or the diameter of the openings is at most 200 μm, electromagnetic wave shielding properties will improve, and when it is at least 5 μm, influences over an image of a PDP will be small.

The width of a metal portion other than the openings is preferably from 5 to 50 μm. That is, the mesh pitch of the openings is preferably from 10 to 250 μm. When the width of the metal portion is at least 5 μm, processing will be easy, and when it is at most 50 μm, influences over an image of a PDP will be small.

If the sheet resistance of the electroconductive mesh layer is lower than necessary, the film tends to be thick, and such will adversely affect optical performance, etc. of the protective plate 1 for a PDP, such that no sufficient openings can be secured. On the other hand, if the sheet resistance of the electroconductive mesh layer is higher than necessary, no sufficient electromagnetic wave shielding properties will be obtained. Accordingly, the surface resistance of the electroconductive mesh layer is preferably from 0.01 to 10 Ω/□, more preferably from 0.01 to 2 Ω/□, particularly preferably from 0.05 to 1 Ω/□.

The sheet resistance of the electroconductive mesh layer can be measured by a four-probe method using electrodes at least five times larger than one side or the diameter of the opening with a distance between electrodes at least five times the mesh pitch of the openings. For example, when 100 μm square openings are regularly arranged with metal portions with a width of 20 μm, the sheet resistance can be measured by arranging electrodes with a diameter of 1 mm with a distance of 1 mm. Otherwise, the electroconductive mesh film is processed into a stripe, electrodes are provided on both ends in the longitudinal direction to measure the resistance R therebetween thereby to determine the sheet resistance from the length a in the longitudinal direction and the length b in the lateral direction in accordance with the following formula:

$$\text{Sheet resistance} = R \times b/a$$

To laminate a copper foil on a transparent film, a transparent adhesive is used. The adhesive may, for example, be an acrylic adhesive, an epoxy adhesive, a urethane adhesive, a silicone adhesive or a polyester adhesive. As a type of the adhesive, a two-liquid type or a thermosetting type is preferred. Further, the adhesive is preferably one having excellent chemical resistance.

As a method of processing a copper foil into a mesh, a photoresist process may be mentioned. In the print process, the pattern of the openings is formed by screen printing or the like. By the photoresist process, a photoresist material is laminated on a copper foil by roll coating, spin coating, overall printing or transferring, followed by exposure, development and etching to form the pattern of the openings. As another method of forming the electroconductive mesh layer, a method of forming the pattern of the openings by the print process such as screen printing may be mentioned.

As the protective plate 1 for a PDP is disposed in front of a PDP, it preferably has a luminous transmittance (stimulus Y stipulated in JIS Z8701) of at least 30%, more preferably at least 35% so as not to prevent an image of the PDP from being seen.

Further, the luminous reflectance is preferably less than 5%, particularly preferably less than 3%. Further, the transmittance at a wavelength of 850 nm is preferably at most 15%, particularly preferably at most 10%.

The above-described protective plate 1 for a PDP comprises a support 20 and an electromagnetic wave shielding film 10 provided on the support 20. Further, an electroconductive film 12 in the electromagnetic wave shielding film 10 has a multilayer structure in which (n+1) (wherein n is an integer of from 3 to 5) inorganic layers 12a each made of a metal oxide having a refractive index of from 1.55 to 2.5 and n metal layers 12b each being a layer made of pure silver or a silver alloy are provided. Such an electromagnetic wave shielding film 10 has high property to shield electromagnetic waves emitted from a PDP (high electrical conductivity i.e. a low sheet resistance), has a broad transmission/reflection band, a high luminous transmittance, a low luminous reflectance and is excellent in near infrared shielding properties. Further, the second to n-th metal layers 12b from the substrate 11 are thicker than the first metal layer 12b from the substrate 11, whereby the luminous reflectance of a protective plate for a PDP can be suppressed low without providing a protective film.

In a case where no protective film is laminated via e.g. an adhesive on the surface of the electroconductive film 12 of the electromagnetic wave shielding film 10 of the present invention, the electroconductive film 12 becomes the outermost layer. That is, the electroconductive film 12 is in direct contact with the air. In such a case, the electromagnetic wave shielding film of the present invention has a low luminous reflectance and consequently, the luminous reflectance of the protective plate for a PDP can be made low. That is, the electromagnetic wave shielding film 10 of the present invention has a low luminous reflectance in a case where the electroconductive film 12 is in contact with the air having a refractive index of 1, and as a result, the luminous reflectance of a protective plate for a PDP can be made low.

Further, in the electromagnetic wave shielding film 10 of the present invention, on the surface of the electroconductive film 12, another layer such as an antifouling agent layer 13 may be laminated so long as it has small optical influences. Namely, the electroconductive film 12 may be in contact with the air via the antifouling agent layer 13. For example, in a case where an antifouling agent layer 13 having a refractive index of from 1.3 to 1.5 and having a thickness of from 2 to 30 nm is laminated on the outermost surface of the electroconductive film 12, the luminous reflectance of the electromagnetic wave shielding film is sufficiently low since the antifouling agent layer 13 has a small optical influence.

The protective plate for a PDP of the present invention can be easily produced, since no protective film has to be laminated on the electromagnetic wave shielding film.

The electromagnetic wave shielding film of the present invention has a low luminous reflectance in a state where there is no protective film on the surface, and accordingly, the protective plate for a PDP of the present invention is preferably disposed so that the electromagnetic wave shielding film is on the PDP side. In a case where the protective plate for a PDP is disposed so that the electromagnetic wave shielding film is on the PDP side, the electromagnetic wave shielding film is hardly touched by human. Accordingly, it is not necessary to laminate a protective film on the surface (the surface of the electroconductive film) of the electromagnetic wave shielding film. That is, the electromagnetic wave shielding film will not be stained even if nothing is laminated on its surface. Further, only by laminating a thin antifouling agent layer (for example, having a thickness of from 2 to 30 nm), stain on the electromagnetic wave shielding film can sufficiently be prevented.

The "protective film" means e.g. a protective film having an antireflection function comprising a substrate of e.g. PET and an antireflection layer or the like formed on the surface of the substrate, provided on the electromagnetic wave shielding film in a conventional protective plate for a PDP.

The protective plate for a PDP of the present invention is not limited to the above-described embodiment. For example, in the above embodiment, a film is laminated via an adhesive layer 70, but bonding by heat may be possible without using a tackifier or an adhesive in some cases.

Further, the protective plate for a PDP of the present invention may have an antireflection resin film or an antireflection layer which is a low refractive index thin film having a refractive index of from 1.3 to 1.5 as the case requires. The antireflection resin film may be one used for a conventional protective plate for a PDP. More excellent antireflection properties will be obtained by use of a fluororesin film.

With respect to the antireflection layer, in order that the reflectance of the protective plate to be obtained is low and the preferred reflected color will be obtained, the wavelength at which the reflectance in the visible range is minimum, is preferably from 500 to 600 nm, particularly preferably from 530 to 590 nm. The antireflection layer is preferably laminated on the opposite side of the substrate from a surface on which the electromagnetic wave shielding film is laminated.

Further, the protective plate for a PDP may be made to have near infrared shielding function. As a method to make the protective plate have near infrared shielding function, a method of using a near infrared shielding film, a method of using a near infrared absorbing substrate, a method of using an adhesive having a near infrared absorber incorporated therein at the time of laminating film, a method of adding a near infrared absorber to an antireflection resin film or the like to make the film or the like have near infrared absorbing function, a method of using an electroconductive film having near infrared reflection function may, for example, be mentioned.

Further, the PDP of the present invention preferably comprises the protective plate for a PDP of the present invention and is preferably disposed so that the surface on the electroconductive film side of the protective plate for a PDP is on the PDP side.

## EXAMPLES

Examples 1 to 18 are Examples of the present invention, and Examples 19 and 20 are Comparative Examples.

## EXAMPLE 1

An electromagnetic wave shielding film 10 shown in Fig. 1 was prepared as follows.

First, dry cleaning by ion beams was carried out for the purpose of cleaning the surface of a PET film having a thickness of 100 μm as a substrate 11 as follows.

About 30 vol% of oxygen gas was mixed with an argon gas, an electric power of 100 W was charged, and argon ions and oxygen ions ionized by an ion beam source were applied to the surface of the substrate 11.

Then, while mixing 3 vol% of an oxygen gas with an argon gas and introducing the gas mixture, pulse sputtering was carried out on the surface of the substrate 11 subjected to dry cleaning using a zinc oxide target (refractive index: 1.93) doped with 5 mass% of alumina under a pressure of 0.35 Pa at a frequency of 100 kHz at an electric power density of 5.8 W/cm$^2$ at a reverse pulse duration of 1 μs to form an inorganic layer 12a(1) having a thickness of 40 nm.

Then, while introducing an argon gas, pulse sputtering was carried out using a silver alloy target doped with 1.0 mass% of gold under a pressure of 0.5 Pa at a frequency of 100 kHz at an electric power density of 0.42 W/cm$^2$ at a reverse pulse duration of 5 μs to form a metal layer 12b(1) having a thickness of 6.8 nm.

Then, while mixing 3 vol% of an oxygen gas with an argon gas and introducing the gas mixture, pulse sputtering was carried out using a zinc oxide target doped with 5 mass% of alumina under a pressure of 0.35 Pa at a frequency of 100 kHz at an electric power density of 5.8 W/cm$^2$ at a reverse pulse duration of 1 μs to form an inorganic layer 12a(2) having a thickness of 80 nm.

Then, while introducing an argon gas, pulse sputtering was carried out using a silver alloy target doped with 1.0 mass% of gold under a pressure of 0.5 Pa at a frequency of 100 kHz at an electric power density of 0.63 W/cm$^2$ at a reverse pulse duration of 5 μs to form a metal layer 12b(2) having a thickness of 11.4 nm.

Then, while mixing 3 vol% of an oxygen gas with an argon gas and introducing the gas mixture, pulse sputtering was carried out using a zinc oxide target doped with 5 mass% of alumina under a pressure of 0.35 Pa at a frequency of 100 kHz at an electric power density of 5.8 W/cm$^2$ at a reverse pulse duration of 1 μs to form an inorganic layer 12a(3) having a thickness of 80 nm.

Then, while introducing an argon gas, pulse sputtering was carried out using a silver alloy target doped with 1.0 mass% of gold under a pressure of 0.5 Pa at a frequency of 100 kHz at an electric power density of 0.73 W/cm$^2$ at a reverse pulse duration of 5 μs to form a metal layer 12b(3) having a thickness of 12.0 nm.

Then, while mixing 3 vol% of an oxygen gas with an argon gas and introducing the gas mixture, pulse sputtering was carried out using a zinc oxide target doped with 5 mass% of alumina under a pressure of 0.35 Pa at a frequency of 100 kHz at an electric power density of 5.2 W/cm$^2$ at a reverse pulse duration of 1 μs to form an inorganic layer 12a(4) having a thickness of 35 nm.

Then, while mixing 5 vol% of an oxygen gas with an argon gas and introducing the gas mixture, pulse sputtering was carried out on the inorganic layer 12a(4) using an ITO target (indium:tin=90:10 mass ratio) under a pressure of 0.35 Pa at a frequency of 100 kHz at an electric power density of 1.3 W/cm$^2$ at a reverse pulse duration of 1 μs to form an ITO layer having a thickness of 5 nm as a waterproof layer 12c.

Then, on the waterproof layer 12c, a fluorocarbon oil repellent (manufactured by DAIKIN INDUSTRIES, tradename: OPTOOL DSX) was applied and dried to form an antifouling agent layer 13 having a thickness of 10 nm.

Of such an electromagnetic wave shielding film 10 thus prepared, the luminous transmittance was 78.86% and the luminous reflectance was 0.50%, as measured by color analyzer (manufactured by Tokyo Denshoku Co., Ltd., TC1800). The transmission spectrum and the reflection spectrum are shown in Figs. 3 and 4, respectively. Further, the sheet resistance (surface resistance) was 1.78 Ω/□ measured by eddy current type resistance measuring apparatus (manufactured by Nagy, SRM12).

EXAMPLE 2

Using the electromagnetic wave shielding film 10 in Example 1, a protective plate 1 for a PDP shown in Fig. 2 was prepared as follows.

A glass plate as a support 20 was cut into a predetermined size, chamfered and cleaned. Then, an ink for a color ceramic layer was applied at the periphery of the glass plate by screen printing and sufficiently dried to form a color ceramic layer 30. Then, the glass plate was heated to 660°C and then air cooled to apply glass tempering treatment.

The electromagnetic wave shielding film 10 was bonded on the color ceramic layer 30 side of the glass plate via an adhesive layer 70.

Then, a polyurethane flexible resin film (manufactured by Asahi Glass Company, Limited, tradename: ARCTOP URP2199, thickness 300 μm) as a shatterproof film 40 was bonded on the rear side of the glass plate (the opposite side from the side on which the electromagnetic wave shielding film 10 was bonded) via an adhesive layer 70. Usually, a coloring agent is added to the polyurethane flexible resin film for color tone correction, Ne cut and the like to improve color reproducibility, but in this Example, the resin film was not colored since no evaluation of the color tone correction and the Ne cut was carried out.

Of the protective plate 1 for a PDP thus prepared, the luminous transmittance was 81.0% and the luminous reflectance was 1.49%, as measured by color analyzer (manufactured by Tokyo Denshoku Co., Ltd., TC1800). The transmission spectrum and the reflection spectrum are shown in Figs. 5 and 6, respectively.

EXAMPLE 3

Under the same conditions as in Example 1, an electroconductive film 12 and an antifouling agent layer 13 are formed on a PET film having a thickness of 100 μm as a substrate 11 to prepare an electromagnetic wave shielding film 14 shown in Fig. 7. However, four metal layers 12b are formed, the thickness of the metal layer 12b(1) is 6.9 nm, the thickness of the metal layer 12b(2) is 10.5 nm, the thickness of the metal layer 12b(3) is 13.2 nm, and the thickness of the metal layer 12b(4) is 14.0 nm. Further, the thickness of the inorganic layer 12a(1) is 40 nm, the thickness of the inorganic layer 12a(2) is 80 nm, the thickness of the inorganic layer 12a(3) is 80 nm, the thickness of the inorganic layer 12a(4) is 80 nm and the thickness of the inorganic layer 12a(5) is 35 nm. Further, as a waterproof layer 12c, an ITO layer having a thickness of 5 nm is formed.

Of the electromagnetic wave shielding film 14, the luminous transmittance is 70.82%, the luminous reflectance is 0.39%, and the sheet resistance (surface resistance) is 1.17 Ω/□. The transmission spectrum and the reflection spectrum are shown in Figs. 8 and 9, respectively.

EXAMPLE 4

In the same manner as in Example 2, using the electromagnetic wave shielding film 14 in Example 3, a protective plate 1 for a PDP is prepared. Of the protective plate 1 for a PDP, the luminous transmittance is 72.77% and the luminous reflectance is 1.13%.

EXAMPLE 5

Under the same conditions as in Example 1, an electroconductive film 12 and an antifouling agent layer 13 are formed on a PET film having a thickness of 100 μm as a substrate 11 to prepare an electromagnetic wave shielding film 15 shown in Fig. 10. However, five metal layers 12b are formed, the thickness of the metal layer 12b(1) is 6.4 nm, the thickness of the metal layer 12b(2) is 9.0 nm, the thickness of the metal layer 12b(3) is 12.0 nm, the thickness of the metal layer 12b(4) is 13.3 nm, and the thickness of the metal layer 12b(5) is 14.0 nm. Further, the thickness of the inorganic layer 12a(1) is 40 nm, the thickness of the inorganic layer 12a(2) is 80 nm, the thickness of the inorganic layer 12a(3) is 80 nm, the thickness of the inorganic layer 12a(4) is 80 nm, the thickness of the inorganic layer 12a(5) is 80 nm, and the thickness of the inorganic layer 12a(6) is 35 nm. Further, as a waterproof layer 12c, an ITO layer having a thickness of 5 nm is formed.

Of the electromagnetic wave shielding film 15, the luminous transmittance is 66.13%, the luminous reflectance is 0.19%, and the sheet resistance (surface resistance) is 0.89 Ω/□. The transmission spectrum and the reflection spectrum are shown in Figs. 11 and 12, respectively.

EXAMPLE 6

In the same manner as in Example 2, using the electromagnetic wave shielding film 15 in Example 5, a protective plate 1 for a PDP is prepared. Of the protective plate 1 for a PDP, the luminous transmittance is 69.26% and the luminous reflectance is 0.98%.

EXAMPLE 7

Under the same conditions as in Example 1, an electroconductive film 12 and an antifouling agent layer 13 are formed on a PET film having a thickness of 100 μm as a substrate 11 to prepare an electromagnetic wave shielding film 14 shown in Fig. 7.

However, the thickness of the metal layer 12b (1) is 7.0 nm, the thickness of the metal layer 12b(2) is 10.7 nm, the thickness of the metal layer 12b(3) is 13.1 nm, and the thickness of the metal layer 12b(4) is 14.1 nm. Further, inorganic layers 12a are formed by using a zinc oxide target (refractive index: 1.96) doped with 5 mass% of gallium oxide, the thickness of the inorganic layer 12a(1) is 40 nm, the thickness of the inorganic layer 12a(2) is 80 nm, the thickness of the inorganic layer 12a (3) is 80 nm, the thickness of the inorganic layer 12a(4) is 80 nm, and the thickness of the inorganic layer 12a(5) is 35 nm. Further, an ITO layer having a thickness of 5 nm is formed as a waterproof layer 12c.

Of the electromagnetic wave shielding film 14, the luminous transmittance is 70.84%, the luminous reflectance is 0.41%, and the sheet resistance (surface resistance) is 1.15 Ω/□.

EXAMPLE 8

In the same manner as in Example 2, using the electromagnetic wave shielding film 14 in Example 7, a protective plate 1 for a PDP is prepared. Of the protective plate 1 for a PDP, the luminous transmittance is 72.63% and the luminous reflectance is 1.15%.

EXAMPLE 9

Under the same conditions as in Example 1, an electroconductive film 12 and an antifouling agent layer 13 are formed on a PET film having a thickness of 100 μm as a substrate 11 to prepare an electromagnetic wave shielding film 14 shown in Fig. 7.

However, the thickness of the metal layer 12b (1) is 7.8 nm, the thickness of the metal layer 12b(2) is 10.0 nm, the thickness of the metal layer 12b(3) is 12.2 nm, and the thickness of the metal layer 12b(4) is 14.9 nm. Further, inorganic layers 12a are formed by using a zinc oxide target (refractive index: 2.06) doped with 10 mass% of titanium oxide, the thickness of the inorganic layer 12a(1) is 40 nm, the thickness of the inorganic layer 12a(2) is 80 nm, the thickness of the inorganic layer 12a (3) is 80 nm, the thickness of the inorganic layer 12a(4) is 80 nm, and the thickness of the inorganic layer 12a(5) is 35 nm. Further, an ITO layer having a thickness of 5 nm is formed as a waterproof layer 12c.

Of the electromagnetic wave shielding film 14, the luminous transmittance is 73.07%, the luminous reflectance is 0.25%, and the sheet resistance (surface resistance) is 0.98 Ω/□.

EXAMPLE 10

In the same manner as in Example 2, using the electromagnetic wave shielding film 14 in Example 9, a protective plate 1 for a PDP is prepared. Of the protective plate 1 for a PDP, the luminous transmittance is 74.11% and the luminous reflectance is 0.99%.

EXAMPLE 11

Under the same conditions as in Example 1, an electroconductive film 12 and an antifouling agent layer 13 are formed on a PET film having a thickness of 100 μm as a substrate 11 to prepare an electromagnetic wave shielding film 10 shown in Fig. 1.

However, the thickness of the metal layer 12b (1) is 8.0 nm, the thickness of the metal layer 12b(2) is 13.4 nm, and the thickness of the metal layer 12b(3) is 14.2 nm. Further, the thickness of the inorganic layer 12a (1) is 40 nm, the thickness of the inorganic layer 12a(3) is 80 nm, and the thickness of the inorganic layer 12a(4) is 35 nm. Further, the inorganic layer 12a(2) has a three layer structure (average refractive index: 1.56) comprising an AZO layer (refractive index: 1.93) of 10.6 nm formed from a zinc oxide target doped with 5 mass% of alumina, a silicon dioxide layer (refractive index: 1.46) of 100 nm formed from a silicon target doped with boron and an AZO layer of 17.5 nm formed from a zinc oxide target doped with 5 mass% of alumina laminated. Further, an ITO layer having a thickness of 5 nm is formed as a waterproof layer 12c.

Of the electromagnetic wave shielding film 10, the luminous transmittance is 71.11%, the luminous reflectance is 0.49%, and the sheet resistance (surface resistance) is 1.33 Ω/□.

EXAMPLE 12

In the same manner as in Example 2, using the electromagnetic wave shielding film 10 in Example 11, a protective plate 1 for a PDP is prepared. Of the protective plate 1 for a PDP, the luminous transmittance is 73.42% and the luminous reflectance is 1.56%.

EXAMPLE 13

Under the same conditions as in Example 1, an electroconductive film 12 and an antifouling agent layer 13 are formed on a PET film having a thickness of 100 μm as a substrate 11 to prepare an electromagnetic wave shielding film 10 shown in Fig. 1.

However, the thickness of the metal layer 12b (1) is 6.9 nm, the thickness of the metal layer 12b(2) is 9.0 nm, and the thickness of the metal layer 12b(3) is 10.4 nm. Further, the thickness of the inorganic layer 12a (1) is 40 nm, the thickness of the inorganic layer 12a(2) is 80 nm, and the thickness of the inorganic layer 12a(3) is 80 nm. Further, the inorganic layer 12a(4) has a two layer structure (average refractive index: 1.60) comprising an AZO layer (refractive index: 1.93) of 20 nm and a silicon dioxide layer (refractive index: 1.46) of 47.0 nm. In this Example, no waterproof layer 12c is provided.

Of the electromagnetic wave shielding film 10, the luminous transmittance is 77.85%, the luminous reflectance is 0.12%, and the sheet resistance (surface resistance) is 2.17 Ω/□.

EXAMPLE 14

In the same manner as in Example 2, using the electromagnetic wave shielding film 10 in Example 13, a protective plate 1 for a PDP is prepared. Of the protective plate 1 for a PDP, the luminous transmittance is 80.02% and the luminous reflectance is 0.90%.

EXAMPLE 15

Under the same conditions as in Example 1, an electroconductive film 12 and an antifouling agent layer 13 are formed on a PET film having a thickness of 100 μm as a substrate 11 to prepare an electromagnetic wave shielding film 10 shown in Fig. 1.

However, the thickness of the metal layer 12b (1) is 7.0 nm, the thickness of the metal layer 12b(2) is 11.0 nm, and the thickness of the metal layer 12b(3) is 10.1 nm. Further, inorganic layers 12a are formed by aluminum oxide layers (refractive index: 1.67) formed in an oxygen atmosphere using an aluminum target as a starting material, and the thickness of the inorganic layer 12a(1) is 50 nm, the thickness of the inorganic layer 12a (2) is 97.6 nm, the thickness of the inorganic layer 12a (3) is 98.7 nm, and the thickness of the inorganic layer 12a(4) is 51.3 nm. In this Example, no waterproof layer 12c is provided.

Of the electromagnetic wave shielding film 10, the luminous transmittance is 76.74%, the luminous reflectance is 0.46%, and the sheet resistance (surface resistance) is 1.99 Ω/□.

EXAMPLE 16

In the same manner as in Example 2, using the electromagnetic wave shielding film 10 in Example 15, a protective plate 1 for a PDP is prepared. Of the protective plate 1 for a PDP, the luminous transmittance is 78.90% and the luminous reflectance is 1.51%.

EXAMPLE 17

An electromagnetic wave shielding film was obtained in the same manner as in Example 1 except that the electric power density was 0.34 W/cm$^2$ when the metal layer 12b(1) was formed and the thickness of the metal layer 12b(1) was 9.1 nm; that the electric power density was 0.41 W/cm$^2$ when the metal layer 12b(2) was formed and the thickness of the metal layer 12b(2) was 10.9 nm; and that the electric power density was 0.37 W/cm$^2$ when the metal layer 12b(3) was formed and the thickness of the metal layer 12b(3) was 10.0 nm.

Of the electromagnetic wave shielding film thus prepared, the luminous transmittance was 78.2% and the luminous reflectance was 2.29%, as measured by color analyzer (manufactured by Tokyo Denshoku Co., Ltd., TC1800). The transmission spectrum and the reflection spectrum are shown in Figs. 3 and 4, respectively.

Further, the sheet resistance (surface resistance) was 1.82 Ω/□ as measured by eddy current type resistance measuring apparatus (manufactured by Nagy, SRM12).

EXAMPLE 18

A protective plate for a PDP was obtained in the same manner as in Example 2 except that the electromagnetic wave shielding film in Example 17 was used instead of the electromagnetic wave shielding film 10 in Example 2.

Of the protective plate for a PDP thus prepared, the luminous transmittance was 80.2% and the luminous reflectance was 2.63%, as measured by color analyzer (manufactured by Tokyo Denshoku Co., Ltd., TC1800). The transmission spectrum and the reflection spectrum are shown in Figs. 5 and 6, respectively.

EXAMPLE 19

An electromagnetic wave shielding film is prepared in the same manner as in Example 1 except that the thickness of the metal layer 12b(1) is 10.0 nm, the thickness of the metal layer 12b(2) is 12.0 nm, the thickness of the metal layer 12b(3) is 12.0 nm, and the thickness of the metal layer 12b(4) is 10.0 nm.

Of the electromagnetic wave shielding film, the luminous transmittance is 69.52%, the luminous reflectance is 2.50%, and the sheet resistance (surface resistance) is 1.31 Ω/□. The transmission spectrum and the reflection spectrum are shown in Figs. 8 and 9, respectively.

EXAMPLE 20

In the same manner as in Example 2, using the electromagnetic wave shielding film in Example 19, a protective plate for a PDP is prepared. Of the protective plate for a PDP, the luminous transmittance is 71.45% and the luminous reflectance is 3.32%.

INDUSTRIAL APPLICABILITY

The electromagnetic wave shielding film for a PDP and the protective plate for a PDP of the present invention suppress the luminous reflectance of the protective plate for a PDP low even without providing a protective film, and can meet requirements for high functionality and reduction in thickness in recent years and are thereby useful.

The entire disclosures of Japanese Patent Application No. 2005-198507 filed on July 7, 2005 and Japanese Patent Application No. 2005-311169 filed on October 26, 2005 including specifications, claims, drawings and summaries are incorporated herein by reference in their entireties.

**Claims**

1. An electromagnetic wave shielding film for a plasma display panel, which comprises a substrate and an electroconductive film formed on the substrate, wherein the electroconductive film has a multilayer structure in which (n+1) (wherein n is an integer of from 3 to 5) inorganic layers having a refractive index of from 1.55 to 2.5 and n metal layers are alternately laminated from the substrate side; each inorganic layer is a layer containing at least one member selected from the group consisting of a metal oxide, a metal nitride and a metal oxynitride; each metal layer is a layer made of pure silver or a layer made of a silver alloy containing at least one member selected from the group consisting of gold, palladium and bismuth; and the second to n-th metal layers from the substrate are thicker than the first metal layer from the substrate.

2. The electromagnetic wave shielding film for a plasma display panel according to Claim 1, wherein when the thickness of the first metal layer from the substrate is 1, the second to n-th metal layers from the substrate have thicknesses of from 1.1 to 2.5.

3. The electromagnetic wave shielding film for a plasma display panel according to Claim 1 or 2, wherein the i-th (wherein i is an integer of from 2 to n) metal layer from the substrate is thicker than the (i-1)-th metal layer from the substrate.

4. The electromagnetic wave shielding film for a plasma display panel according to Claim 3, wherein when the thickness of the (i-1)-th metal layer from the substrate is 1, the i-th metal layer from the substrate has a thickness of from 1.05 to 2.5.

5. The electromagnetic wave shielding film for a plasma display panel according to any one of Claims 1 to 4, wherein n is 3.

6. The electromagnetic wave shielding film for a plasma display panel according to any one of Claims 1 to 5, which further has an antifouling agent layer on the electroconductive layer.

7. The electromagnetic wave shielding film for a plasma display panel according to Claim 6, wherein the antifouling agent layer has a refractive index of from 1.3 to 1.5.

8. The electromagnetic wave shielding film for a plasma display panel according to Claim 6 or 7, wherein the antifouling agent layer has a thickness of from 2 to 30 nm.

9. The electromagnetic wave shielding film for a plasma display panel according to any one of Claims 1 to 8, wherein each inorganic layer contains at least one member selected from the group consisting of zinc oxide, indium oxide, tin oxide, titanium oxide and niobium oxide.

**10.** The electromagnetic wave shielding film for a plasma display panel according to any one of Claims 1 to 9, wherein each inorganic layer is a layer made of zinc oxide containing at least one element selected from the group consisting of tin, aluminum, chromium, titanium, silicon, boron, magnesium and gallium.

**11.** A protective plate for a plasma display panel comprising a support and the electromagnetic wave shielding film for a plasma display panel as defined in any one of Claims 1 to 10 formed on the support.

**12.** The protective plate for a plasma display panel according to Claim 11, wherein the surface of the substrate opposite from the surface on which the electroconductive film is formed in the electromagnetic wave shielding film for a plasma display panel, and one surface of the support, are bonded.

**13.** A plasma display panel comprising the protective plate for a plasma display panel as defined in Claim 12 disposed so that the surface on the electroconductive film side of the protective plate is on the plasma display panel side.

Fig. 1

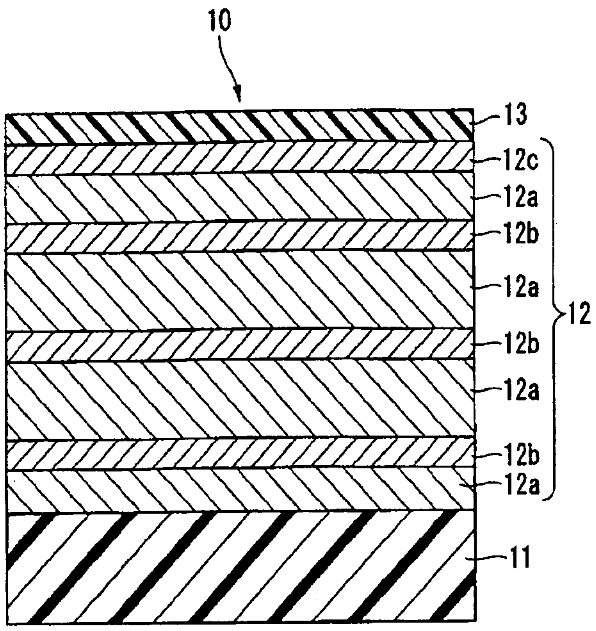
10
13
12c
12a
12b
12a
12
12b
12a
12b
12a
11

Fig. 2

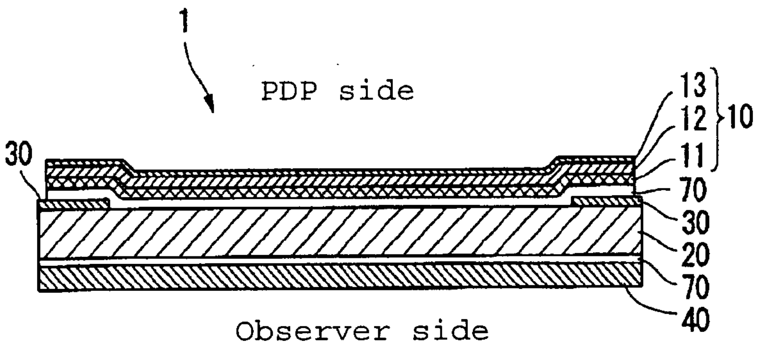
1
PDP side
13
12
10
11
70
30
30
20
70
40
Observer side

Fig. 3

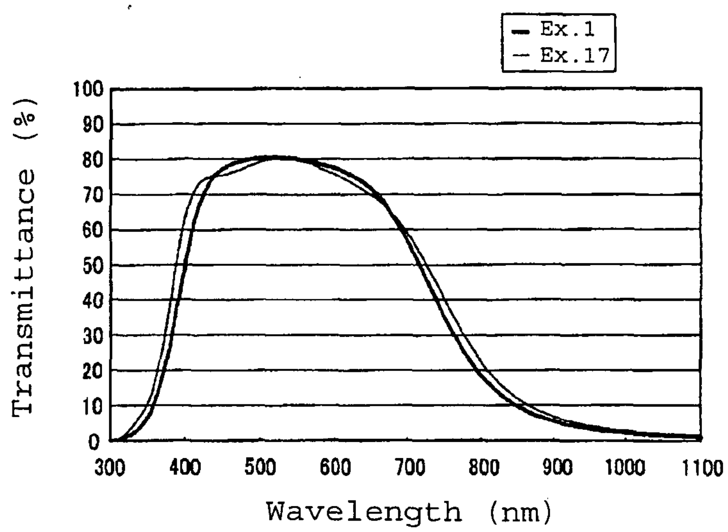
Ex.1
Ex.17
100
90
80
70
60
50
40
30
20
10
0
Transmittance (%)
300
400
500
600
700
800
900
1000
1100
Wavelength (nm)

Fig. 4

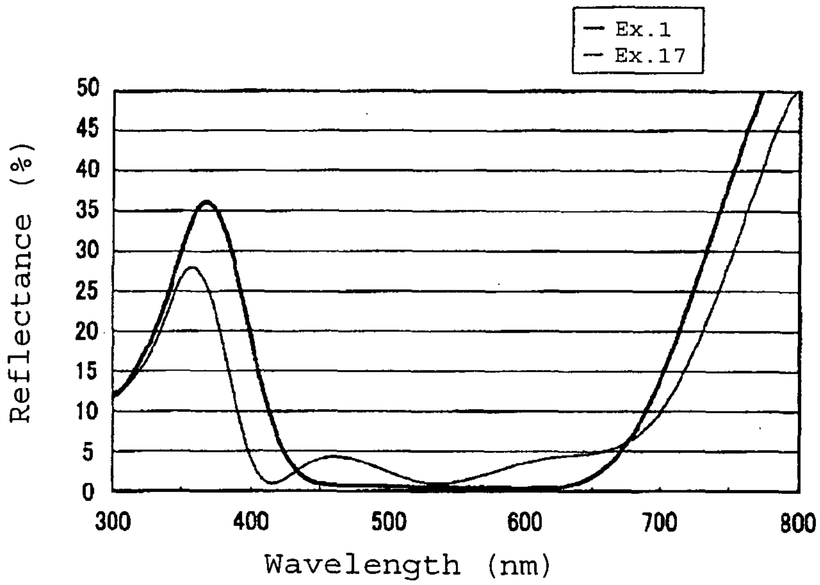
Ex.1
Ex.17
50
45
40
35
30
25
20
15
10
5
0
Reflectance (%)
300
400
500
600
700
800
Wavelength (nm)

Fig. 5

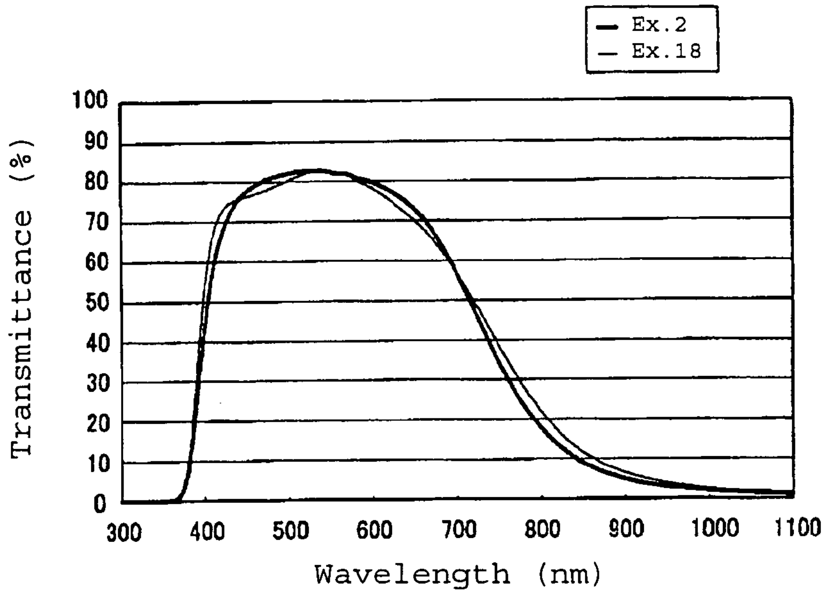
Ex.2
Ex.18
100
90
80
70
60
50
40
30
20
10
0
Transmittance (%)
300
400
500
600
700
800
900
1000
1100
Wavelength (nm)

Fig. 6

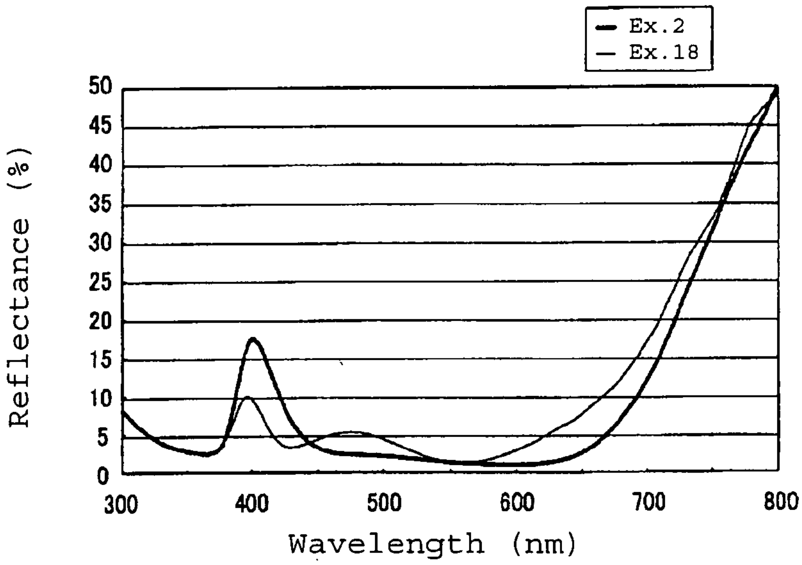
Ex.2
Ex.18
50
45
40
35
30
25
20
15
10
5
0
Reflectance (%)
300
400
500
600
700
800
Wavelength (nm)

Fig. 7

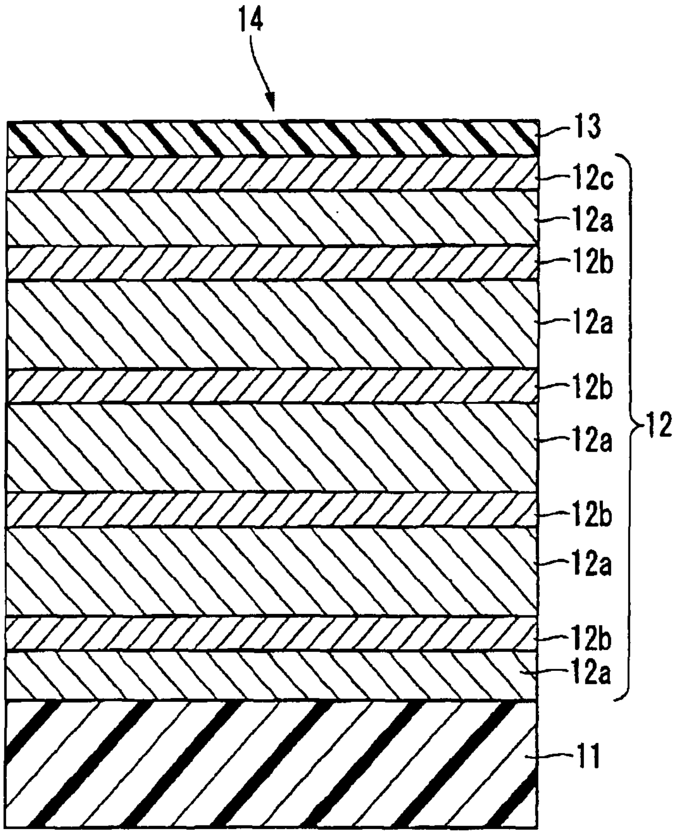
14
13
12c
12a
12b
12a
12b
12a
12b
12a
12b
12a
12
11

Fig. 8

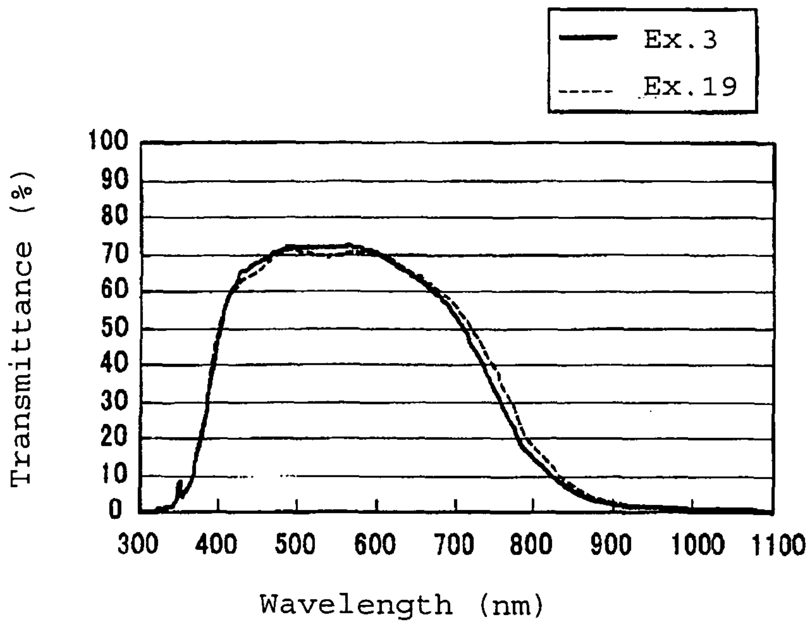
Ex.3
Ex.19
Transmittance (%)
100
90
80
70
60
50
40
30
20
10
0
300
400
500
600
700
800
900
1000
1100
Wavelength (nm)

Fig. 9

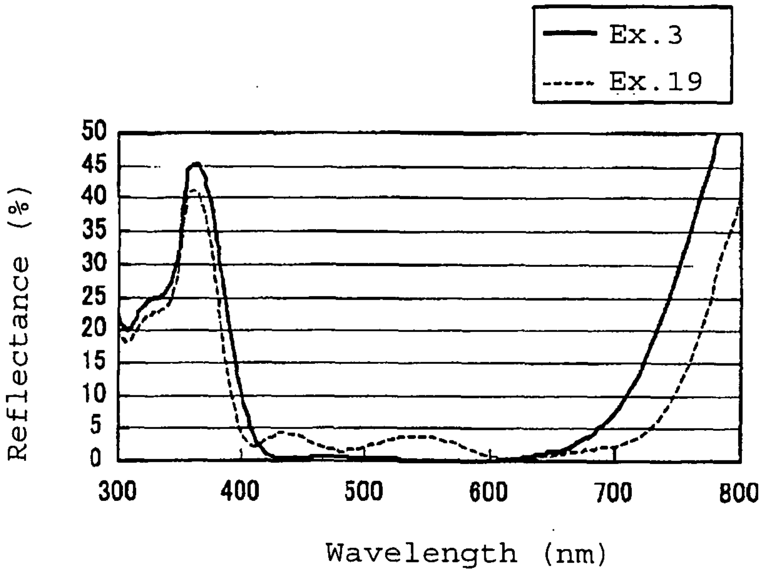
Ex.3
Ex.19
Reflectance (%)
50
45
40
35
30
25
20
15
10
5
0
300
400
500
600
700
800
Wavelength (nm)

Fig. 10

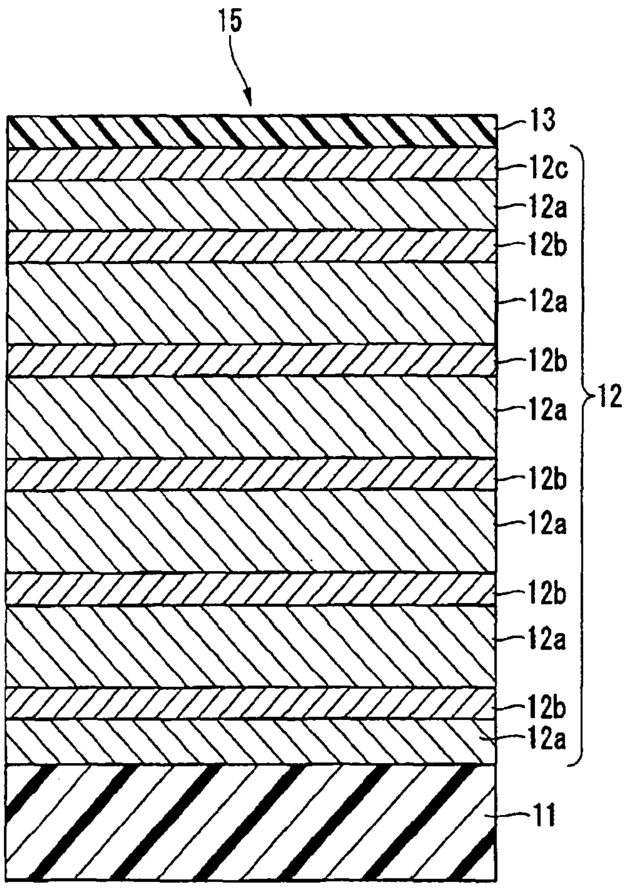
15
13
12c
12a
12b
12a
12b
12a
12b
12a
12b
12a
12b
12a
12
11

Fig. 11

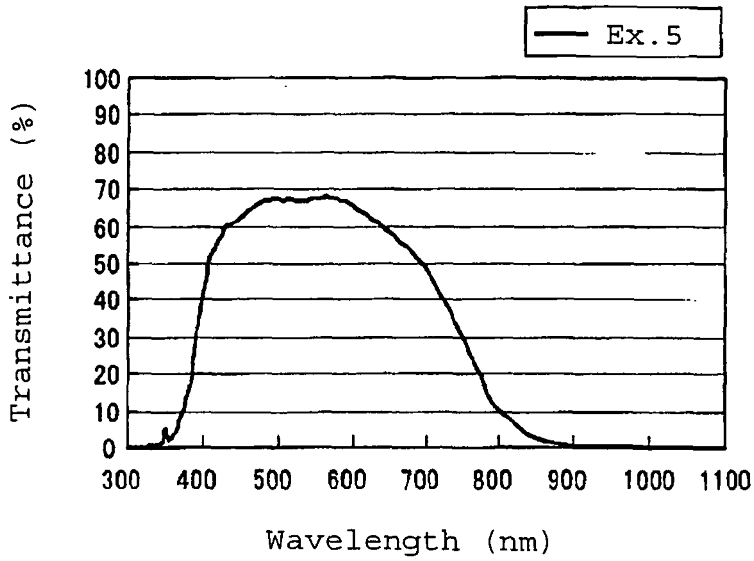
Ex.5
Transmittance (%)
100
90
80
70
60
50
40
30
20
10
0
300
400
500
600
700
800
900
1000
1100
Wavelength (nm)

Fig. 12

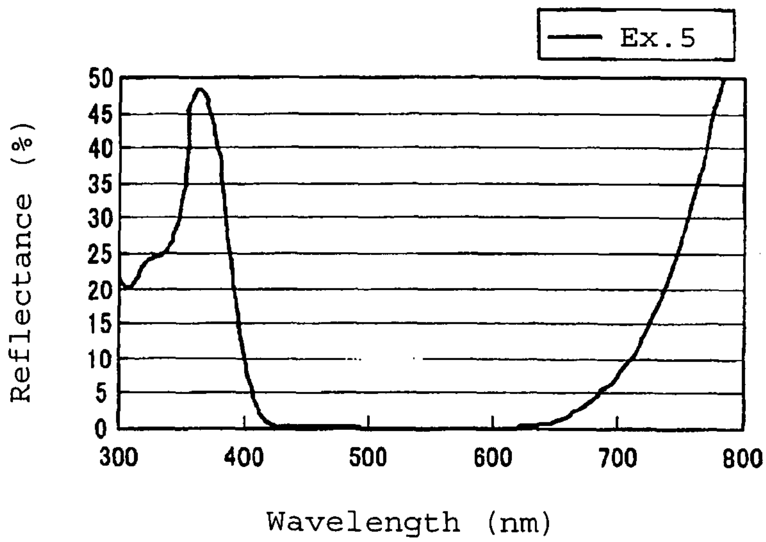
Ex.5
Reflectance (%)
50
45
40
35
30
25
20
15
10
5
0
300
400
500
600
700
800
Wavelength (nm)

**INTERNATIONAL SEARCH REPORT**

International application No.
PCT/JP2006/313433

A. CLASSIFICATION OF SUBJECT MATTER
*H05K9/00*(2006.01)i, *B32B9/00*(2006.01)i, *B32B15/04*(2006.01)i, *G09F9/00*(2006.01)i

According to International Patent Classification (IPC) or to both national classification and IPC

B. FIELDS SEARCHED

Minimum documentation searched (classification system followed by classification symbols)
H05K9/00, B32B9/00, B32B15/04, G09F9/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2000-158578 A (Mitsui Chemicals, Inc.), 13 June, 2000 (13.06.00), Par. Nos. [0001], [0008], [0021] to [0023], [0026], [0030], [0087], [0088]; Figs. 1 to 6 (Family: none) | 1-5<br>6-13 |
| Y | JP 2000-98131 A (Nitto Denko Corp.), 07 April, 2000 (07.04.00), Par. No. [0021] & US 6333592 B1 & EP 990928 A1 & DE 69922605 T | 6-13 |
| Y | JP 2003-92490 A (Tomoegawa Paper Co., Ltd.), 28 March, 2003 (28.03.03), Par. Nos. [0062], [0063] (Family: none) | 7-13 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>05 September, 2006 (05.09.06) | Date of mailing of the international search report<br>12 September, 2006 (12.09.06) |
| Name and mailing address of the ISA/<br>Japanese Patent Office<br>Facsimile No. | Authorized officer<br><br>Telephone No. |

Form PCT/ISA/210 (second sheet) (April 2005)

**INTERNATIONAL SEARCH REPORT**

International application No.
PCT/JP2006/313433

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-72255 A (Asahi Glass Co., Ltd.), 17 March, 2005 (17.03.05), Par. No. [0014] (Family: none) | 10-13 |
| A | JP 2000-294980 A (Nippon Sheet Glass Co., Ltd.), 20 October, 2000 (20.10.00), Full text; Figs. 1 to 5 & US 2002/086164 A1 & EP 1043606 A1 & CN 1269699 A | 1-13 |
| A | WO 2005/020655 A1 (Asahi Glass Co., Ltd.), 03 March, 2005 (03.03.05), Full text; Fig. 1 & US 2005/095449 A1 & EP 1659845 A1 | 1-13 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 9813850 A
- US 6391462 B
- JP 2005198507 A
- JP 2005311169 A